(19) Europäisches Patentamt
European Patent Office
Office européen des brevets

(11) **EP 2 591 549 B1**

(12) **FASCICULE DE BREVET EUROPEEN**

(45) Date de publication et mention
de la délivrance du brevet:
**24.12.2014 Bulletin 2014/52**

(21) Numéro de dépôt: **11746592.2**

(22) Date de dépôt: **04.07.2011**

(51) Int Cl.:
*H03H 9/24* (2006.01)    *H03H 9/02* (2006.01)

(86) Numéro de dépôt international:
**PCT/FR2011/000389**

(87) Numéro de publication internationale:
**WO 2012/004469 (12.01.2012 Gazette 2012/02)**

(54) **MODULE DE DÉCOUPLAGE MÉCANIQUE D'UN RÉSONATEUR À GRAND COEFFICIENT DE QUALITÉ**

MODUL ZUR MECHANISCHEN ABKOPPLUNG EINES RESONATORS MIT HOHEM QUALITÄTSFAKTOR

MODULE FOR THE MECHANICAL UNCOUPLING OF A RESONATOR HAVING A HIGH QUALITY FACTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.07.2010 FR 1002829**

(43) Date de publication de la demande:
**15.05.2013 Bulletin 2013/20**

(73) Titulaire: **Office National d'Etudes et de Recherches Aérospatiales (ONERA)**
**92320 Châtillon (FR)**

(72) Inventeurs:
• **BAHRIZ, Michaël**
**F-77370 La Chapelle Rablais (FR)**
• **LE TRAON, Olivier**
**F-31430 Vauhallan (FR)**

(74) Mandataire: **Bezault, Jean**
**Cabinet Netter**
**36, avenue Hoche**
**75008 Paris (FR)**

(56) Documents cités:
**DE-A1- 2 148 064    US-A1- 2007 216 496**

• **MATTILA T ET AL: "A 12 MHz micromechanical bulk acoustic mode oscillator", SENSORS AND ACTUATORS A, ELSEVIER SEQUOIA S.A., LAUSANNE, CH, vol. 101, no. 1-2, 30 septembre 2002 (2002-09-30), pages 1-9, XP004380143,**
• **BUSER R A ET AL: "Very high Q-factor resonators in monocrystalline silicon", SENSORS AND ACTUATORS A, ELSEVIER SEQUOIA S.A., LAUSANNE, CH, vol. 21, no. 1-3, 1 février 1990 (1990-02-01), pages 323-327, XP026580047,**

**Description**

L'invention se rapporte au domaine des résonateurs mécaniques permettant de réaliser des instruments de mesure du temps ou de la fréquence.

Plus particulièrement, l'invention concerne un module de découplage mécanique d'un résonateur à grand coefficient de qualité destiné par exemple à des horloges de haute stabilité appelées « Oscillateurs Ultra Stables » (OUS).

Les OUS sont constitués d'un tel résonateur mécanique et d'une boucle électronique oscillatrice qui permet d'entretenir la vibration du résonateur à sa fréquence de résonance mécanique. Ainsi, la stabilité de la fréquence du signal électrique alternatif présent dans la boucle électronique bénéficie de la stabilité de la fréquence de la résonance mécanique du résonateur, généralement beaucoup plus grande que celle d'une boucle oscillatrice purement électronique.

La stabilité de la fréquence de résonance du résonateur mécanique est d'autant plus grande que le coefficient de qualité de la vibration de résonance est élevé, autrement dit que l'énergie de vibration contenue dans le résonateur est grande vis-à-vis de l'énergie perdue par période de la vibration. Il existe deux types de pertes d'énergie, d'une part les pertes intrinsèques dues par exemple à l'amortissement visqueux du matériau constituant le résonateur, d'autre part les pertes extrinsèques dues par exemple à un amortissement gazeux ou à une fixation inadaptée du résonateur. C'est pour cela que les meilleurs résonateurs sont réalisés dans des matériaux de très faible amortissement visqueux tels le quartz, qu'ils sont conditionnés sous vide dans un boîtier, et qu'ils sont fixés dans ce boîtier à l'emplacement de ce qu'il est convenu d'appeler idéalement un noeud de vibration.

Il existe une formulation pratique pour exprimer la contribution des différentes sources de pertes d'énergie, ainsi qu'il est expliqué dans ce qui suit.

L'expression du coefficient de qualité réel du résonateur s'écrit :

$$\texttt{Q réel = 2}\boldsymbol{\pi}\texttt{.E/}\Delta\texttt{E}$$

Où E est l'énergie contenue dans le résonateur et $\Delta$E l'énergie perdue par période de la vibration. Pour les exemples précédemment cités, $\Delta$E peut s'écrire :

$$\Delta\texttt{E = }\Delta\texttt{E intrinsèque + }\Delta\texttt{E gaz + }\Delta\texttt{E fixation}$$

On peut donc écrire :

$$\texttt{1/Q réel = (}\Delta\texttt{E intrinsèque + }\Delta\texttt{E gaz + }\Delta\texttt{E fixation)/2}\boldsymbol{\pi}\texttt{.E}$$

Soit :

$$\texttt{1/Q réel = }\Delta\texttt{E intrinsèque/2}\boldsymbol{\pi}\texttt{.E + }\Delta\texttt{E gaz/2}\boldsymbol{\pi}\texttt{.E +}$$
$$\Delta\texttt{E fixation/2}\boldsymbol{\pi}\texttt{.E}$$

Ainsi, on peut associer à chaque source de pertes d'énergie un facteur de qualité qui lui est propre, et écrire :

$$\texttt{1/Q réel = 1/Q intrinsèque + 1/Q gaz + 1/Q fixation}$$

Pour que le coefficient de qualité réel du résonateur soit proche de son coefficient de qualité intrinsèque, il faut donc que les coefficients de qualité associés aux différentes sources de pertes extrinsèques soient très supérieurs au coefficient de qualité intrinsèque. A titre d'exemple, si Q intrinsèque est de l'ordre de $10^6$, il est souhaitable que Q fixation et Q gaz soient de l'ordre d'au moins $10^7$.

L'invention concerne en particulier les pertes dues à la fixation du résonateur, et vise à obtenir que Q fixation soit très supérieur à Q intrinsèque.

La fixation d'un résonateur à l'emplacement d'un noeud de vibration est une notion facile à appréhender dans le cas d'école d'une fixation ponctuelle et d'un modèle de résonateur à une seule dimension spatiale. Par contre, dans le cas réel d'un résonateur en trois dimensions tenu à l'emplacement d'une zone de fixation de dimensions nécessairement non nulles, le problème est généralement complexe à résoudre et nécessite la mise en oeuvre d'un module de découplage mécanique. Ce module de découplage mécanique est partie intégrante d'un dispositif englobant le résonateur. Il doit être réalisé dans un matériau de très faible amortissement visqueux et doit permettre que le dispositif présente une zone suffisamment découplée de la vibration mécanique du résonateur. Ainsi, la fixation de cette zone dans le boîtier n'altère pas le coefficient de qualité du résonateur. Cette zone de fixation peut être vue comme un noeud de vibration du dispositif. Il est entendu que plus la qualité intrinsèque du résonateur est élevée, plus l'efficacité du module de découplage doit être grande.

Pour les résonateurs à grands coefficients de qualité destinés aux OUS, il est connu que le dispositif est monolithique et est constitué d'une pastille de quartz vibrant en cisaillement d'épaisseur et fixée à sa périphérie (brevet US n° 4,381,471). L'une des faces de la pastille est plane et l'autre face est convexe, ce qui permet que l'énergie de vibration soit principalement située dans la région centrale de la pastille (région de plus forte épaisseur) et s'évanouisse progressivement jusqu'à disparaître complètement à la périphérie. Ainsi, la région centrale de la pastille peut être vue comme étant le résonateur, la périphérie étant la zone de fixation, et le reste de la pastille comme étant le module de découplage mécanique. Des électrodes métalliques déposées sur les grandes faces de la pastille au niveau de la région centrale permettent d'exciter par effet piézoélectrique la vibration du résonateur. Il faut noter que ce dispositif fonctionne également en vibration d'extension-compression d'épaisseur, selon le même principe de fonctionnement du découplage mécanique lié à la convexité de l'une des faces de la pastille.

Ce dispositif connu de la technique antérieure fonctionne remarquablement bien puisqu'il procure un découplage mécanique suffisamment efficace pour ne pas altérer le grand coefficient de qualité intrinsèque du résonateur. Ce dispositif connu est généralement fixé au moyen de supports métalliques assemblés chacun à une extrémité sur la périphérie de la pastille et à l'autre extrémité sur une traversée étanche du boîtier, ce qui permet de réaliser facilement la liaison électrique entre les traversées étanches du boîtier et les électrodes métalliques déposées sur la pastille.

Il est connu également de pratiquer des enlèvements de matière au voisinage de la périphérie de la pastille afin que le dispositif comporte une couronne périphérique reliée par des ponts à une pastille centrale plus petite que la pastille d'origine, et d'amincir ces ponts dans la dimension d'épaisseur de la pastille (brevet FR n° 2 338 607 ou son équivalent US n° 4,135,108). La fixation de ce dispositif est effectuée au niveau de la couronne périphérique, ce qui permet de préserver la pastille centrale d'effets parasites dus par exemple à la température ou à la présence d'un champ d'accélération. Mais la couronne et les ponts n'apportent rien vis-à-vis du découplage mécanique de la vibration du résonateur, le découplage mécanique étant toujours obtenu par la convexité de l'une des faces de la pastille.

Cependant, ces dispositifs connus présentent un inconvénient lié à la difficulté de réaliser avec une précision suffisante la face convexe de la pastille, en ce qui concerne notamment le respect de la valeur précise du rayon de courbure optimal. Cette exigence nécessite donc de mettre en oeuvre un procédé de contrôle et de retouche de polissage de chaque exemplaire réalisé, ce qui conduit à un coût de fabrication élevé.

DE 2 148 064 AI divulgue un résonateur étant formé d'un cylindre droit vibrant selon un mode d'extension-compression suivant son axe central longitudinal. Il présente un noeud de vibration dans son plan médian perpendiculaire de l'axe longitudinal. Cette vibration induit naturellement des déformations radiales d'extension-compression.

L'invention a notamment pour but de surmonter l'inconvénient de la technique antérieure en proposant un dispositif comportant un module de découplage mécanique aussi efficace mais réalisable au moyen d'un usinage peu coûteux.

A cette fin, le dispositif comportant un résonateur et un module de découplage mécanique, le résonateur étant formé d'un cylindre droit vibrant selon un mode d'extension-compression suivant son axe central longitudinal et présentant un noeud de vibration dans son plan médian perpendiculaire audit axe longitudinal, ladite vibration induisant naturellement des déformations radiales d'extension-compression, est caractérisé en ce que le module de découplage comporte un cylindre droit creux entourant à distance le résonateur et ayant son axe central longitudinal et son plan médian confondus respectivement avec ceux du résonateur, la hauteur dudit cylindre creux étant sensiblement égale à celle du résonateur, et une membrane disposée dans ledit plan médian et solidaire de la surface cylindrique du résonateur et de la surface cylindrique intérieure du cylindre creux, et que le cylindre creux vibre selon un mode d'extension-compression suivant son axe longitudinal en opposition de phase avec la vibration du résonateur, ce grâce à quoi les effets des déformations radiales du cylindre creux et du résonateur se compensent dans une zone située sur la surface extérieure du cylindre creux au voisinage dudit plan médian.

Les vibrations simultanées et en opposition de phase du résonateur et du cylindre creux correspondent à un mode de résonance mécanique particulier du dispositif selon l'invention, une condition d'existence de ce mode étant que le résonateur et le cylindre creux aient sensiblement la même hauteur.

Ainsi, ladite zone située sur la surface extérieure du cylindre creux peut être découplée de la vibration du résonateur et il est possible, en fixant le dispositif sur ladite zone, d'obtenir que le coefficient de qualité réel du résonateur soit voisin de son grand coefficient de qualité intrinsèque. Afin d'obtenir le découplage maximal, le dimensionnement du dispositif est optimisé par exemple au moyen de simulations numériques basées sur la méthode des éléments finis.

De plus, le dispositif peut être réalisé dans une plaque plane de matériau dont la dimension d'épaisseur est portée par l'axe longitudinal du résonateur, au moyen d'un usinage peu coûteux effectué sur les deux faces de la plaque jusqu'à atteindre une profondeur correspondant à la membrane. A titre d'exemple, le dispositif est réalisé par usinage chimique collectif d'une plaque de quartz selon un procédé voisin de celui pratiqué dans l'industrie horlogère pour la fabrication des quartz de montre.

Les caractéristiques et avantages de l'invention apparaîtront plus clairement à la lecture de la description détaillée et des figures qui s'y rapportent dans lesquelles :

- la figure 1A est une vue en perspective d'un dispositif monolithique selon une première forme de réalisation de l'invention adaptée à un matériau isotrope ;
- la figure 1B est une vue en perspective et en coupe longitudinale du dispositif de la figure 1A ;
- les figures 2A et 2B montrent des déformations exagérément agrandies du résonateur en vibration, dans le but d'illustrer que la vibration d'extension-compression du résonateur suivant son axe longitudinal induit naturellement des déformations radiales d'extension-compression, appelées effets de Poisson ;
- la figure 3A est une vue analogue à la figure 1A montrant la zone de fixation du dispositif ;
- la figure 3B est une vue analogue à la figure 1B montrant des déplacements longitudinaux du résonateur et du cylindre creux ainsi que les effets de Poisson associés ;
- la figure 4 montre une manière de tenir le dispositif de la figure 3A au moyen de supports métalliques ;
- les figures 5A et 5B montrent une manière de tenir le dispositif de la figure 3A au moyen d'un système de fixation intégré ;
- les figures 6A et 6B montrent un dispositif monolithique selon une deuxième forme de réalisation de l'invention, comprenant un cylindre creux additionnel entourant à distance le cylindre creux précité et destiné à obtenir que l'efficacité du module de découplage mécanique s'accommode de tolérances de fabrication plus larges ;
- les figures 7A et 7B montrent un dispositif monolithique selon une troisième forme de réalisation de l'invention adaptée au quartz ; et
- les figures 8A et 8B montrent un dispositif non monolithique selon une quatrième forme de réalisation de l'invention adaptée au silicium.

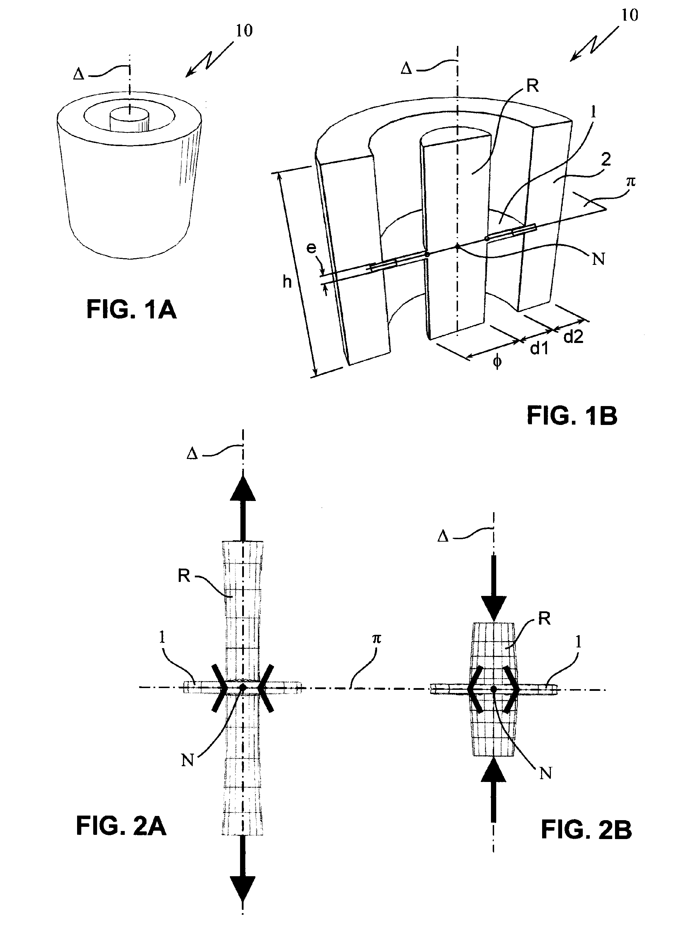

On se réfère d'abord à la **figure 1A** qui montre une vue en perspective d'un dispositif 10 selon l'invention et à la **figure 1B** qui montre une vue en perspective et en coupe longitudinale du dispositif de la figure 1A. Le dispositif 10 comporte un résonateur R formé d'un cylindre droit de directrice circulaire et d'axe central longitudinal $\Delta$, symétrique par rapport à un plan médian $\pi$ perpendiculaire audit axe longitudinal, un cylindre droit creux 2 de directrices circulaires, entourant à distance le résonateur et ayant son axe central longitudinal et son plan médian confondus respectivement avec ceux du résonateur, et une membrane 1 disposée dans ledit plan médian et solidaire de la surface cylindrique du résonateur et de la surface cylindrique intérieure du cylindre creux.

Le cylindre creux 2 et la membrane 1 constituent le module de découplage mécanique du dispositif 10.

Selon la représentation illustrée, le résonateur R et le cylindre creux 2 ont la même dimension de hauteur h. Il est important pour le fonctionnement du dispositif que le résonateur R et le cylindre creux 2 aient sensiblement la même hauteur, ainsi qu'il sera expliqué plus loin.

On appellera $\phi$ le diamètre du résonateur R, d1 et e respectivement la dimension radiale et l'épaisseur de la membrane 1, et d2 l'épaisseur de la paroi du cylindre creux 2, c'est-à-dire la différence entre son rayon extérieur et son rayon intérieur.

Le dispositif 10 est monolithique et réalisé dans une plaque plane de matériau isotrope de très faible amortissement visqueux, tel la silice. La dimension d'épaisseur de la plaque est portée par l'axe longitudinal $\Delta$ du résonateur et est égale à la hauteur h précédemment citée. La réalisation du dispositif 10 est obtenue par exemple par un usinage plasma effectué sur les deux faces de la plaque jusqu'à atteindre une profondeur correspondant à la membrane.

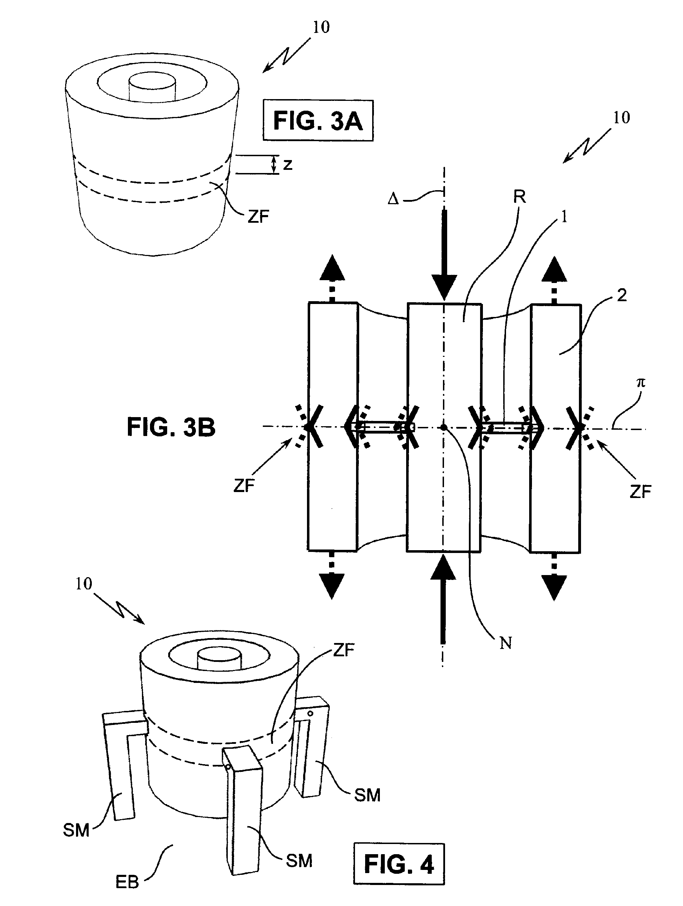

Le fonctionnement du dispositif selon l'invention est maintenant expliqué en relation avec les figures 2A,2B, 3A et 3B.

Les **figures 2A et 2B** sont des vues en coupe longitudinale du résonateur R et de la membrane 1 de la figure 1B, et montrent des déformations exagérément agrandies du résonateur vibrant alternativement en extension (figure 2A) et en compression (figure 2B) suivant son axe longitudinal $\Delta$ et présentant un noeud de vibration N dans son plan médian $\pi$. Ladite vibration d'extension-compression induit naturellement des déformations radiales d'extension-compression dues au coefficient de Poisson du matériau, ces déformations radiales étant maximales dans le plan médian $\pi$ et nulles aux extrémités du résonateur. Ainsi, la vibration du résonateur présente un seul noeud de vibration (N) situé sur l'axe longitudinal $\Delta$, c'est-à-dire au coeur de la matière du résonateur. Sur les figures, les déformations longitudinales sont indiquées à l'aide de flèches en forme de vecteur et les déformations radiales à l'aide de flèches en forme de V.

Pour que la vibration d'extension-compression du résonateur suivant son axe longitudinal soit suffisamment pure, c'est-à-dire que les sections transversales du résonateur ne subissent pratiquement que les translations longitudinales et déformations radiales précédemment indiquées, il est nécessaire que la hauteur h du résonateur soit nettement supérieure à son diamètre φ. De préférence, la hauteur h est comprise entre trois fois et dix fois le diamètre φ.

La disposition de la membrane 1 dans le plan médian π est avantageuse au regard des déformations du résonateur suivant son axe longitudinal, car elle permet que ladite membrane reste dans ledit plan médian lors de la vibration du résonateur, mais les déformations radiales alternativement d'extension et de compression du résonateur dans le plan médian π agissent directement sur la membrane 1 et provoquent en particulier des variations alternatives de son diamètre extérieur.

En d'autres termes, il ne serait pas avantageux que la membrane 1 soit directement fixée dans le boîtier, car il en résulterait des pertes de l'énergie de vibration du résonateur. Cependant, la disposition de la membrane 1 dans le plan médian π peut être vue comme un premier atout vis-à-vis du découplage mécanique de la vibration du résonateur. On précise que cette considération n'a de sens que si l'épaisseur e de la membrane est suffisamment faible en regard de la hauteur h du résonateur. De préférence, l'épaisseur e est inférieure à un vingtième de la hauteur h. Par ailleurs, il est important que la dimension radiale d1 de la membrane ne soit pas trop grande vis-à-vis de son épaisseur e, afin d'éviter que des modes parasites de résonance mécanique de la membrane ne viennent perturber le fonctionnement du dispositif selon l'invention. De préférence, la dimension d1 est inférieure ou égale à vingt fois l'épaisseur e.

En se référant aux **figures 3B et 3A,** il est maintenant expliqué comment le cylindre creux 2 entourant le résonateur R permet d'obtenir un excellent découplage mécanique de la vibration du résonateur. La figure 3B est une vue analogue à la figure 1B indiquant par des flèches, lorsque le résonateur R est en vibration de résonance, des déformations longitudinales du résonateur et du cylindre creux 2 ainsi que les déformations radiales associées. Les flèches correspondant au cylindre creux sont représentées en pointillé. Le cylindre creux vibre selon un mode d'extension-compression suivant son axe longitudinal en opposition de phase avec la vibration du résonateur. Il est important de souligner que les vibrations simultanées et en opposition de phase du résonateur et du cylindre creux correspondent à un mode de résonance mécanique particulier du dispositif selon l'invention, un peu à la manière des vibrations simultanées et en opposition de phase des deux branches sensiblement identiques d'un diapason en vibration de résonance. Pour le dispositif selon l'invention, une condition d'existence dudit mode de résonance particulier est que le résonateur R et le cylindre creux 2 aient sensiblement la même hauteur, ce grâce à quoi les vibrations de résonance en extension-compression du résonateur et du cylindre creux considérés séparément ont des fréquences voisines. Lorsque cette condition est respectée, la membrane 1 solidaire de ces deux éléments permet de procurer un couplage mécanique fort entre leurs vibrations, un peu à la manière du pied solidaire des deux branches d'un diapason, et d'obtenir ainsi l'existence du mode de résonance particulier précité.

Alors que les deux branches sensiblement identiques d'un diapason ont des amplitudes de vibration sensiblement identiques, les amplitudes de vibration du résonateur R et du cylindre creux 2 du dispositif selon l'invention sont généralement très différentes l'une de l'autre, car la masse du cylindre creux est généralement très supérieure à celle du résonateur. Il en découle que l'amplitude de vibration du cylindre creux est généralement très inférieure à celle du résonateur, afin que s'équilibrent naturellement les quantités de mouvement mises en jeu dans le mode de résonance particulier du dispositif selon l'invention. Le lecteur aura noté que les dimensions radiales du cylindre creux, en particulier l'épaisseur d2 de sa paroi, sont des paramètres dimensionnels qui permettent, sans toucher à l'existence du mode de résonance particulier du dispositif, d'ajuster dans une certaine mesure le rapport des amplitudes de vibration du cylindre creux et du résonateur. Cette latitude est mise à profit dans le dispositif selon l'invention ainsi qu'il est expliqué dans ce qui suit.

Toujours en se référant à la figure 3B, les déformations longitudinales du cylindre creux induisent des déformations radiales de sa paroi. Plus précisément, une extension longitudinale induit une compression de l'épaisseur d2 de la paroi, et une compression longitudinale induit une extension de l'épaisseur d2. Dans les deux cas, cela provoque sur les surfaces cylindriques extérieures et intérieures du cylindre creux des déplacements radiaux respectivement opposés, ce qui permet d'obtenir deux qualités propres au dispositif selon l'invention.

La première qualité est due au fait que les déplacements radiaux de la surface cylindrique intérieure du cylindre creux sont de même sens que ceux de la surface cylindrique du résonateur, ce qui contribue à créer par l'intermédiaire de la membrane 1 le couplage mécanique fort précité entre les vibrations du résonateur et du cylindre creux.

La seconde qualité propre au dispositif selon l'invention est due au fait que, sur la surface cylindrique extérieure du cylindre creux, les déplacements radiaux dus aux déformations radiales dudit cylindre creux sont de sens opposé à ceux dus aux déformations radiales du résonateur, ce qui permet que leurs effets se compensent dans une zone située sur la surface extérieure du cylindre creux au voisinage du plan médian π. Ainsi, ladite zone peut être quasiment découplée de la vibration du résonateur et il est possible, en fixant le dispositif sur ladite zone, d'obtenir que le coefficient de qualité réel du résonateur soit voisin de son grand coefficient de qualité intrinsèque. Ladite zone, appelée zone de fixation, est référencée ZF et délimitée par des pointillés sur la figure 3A. La zone de fixation ZF est une surface cylindrique de hauteur z ayant le même plan médian (π) que le résonateur et le cylindre creux. La hauteur z est généralement supérieure à l'épaisseur e de la membrane 1. Par exemple, la hauteur z peut être égale à deux fois l'épaisseur e, ce qui est relativement confortable pour disposer un système de fixation sur la zone ZF ainsi qu'il sera vu plus loin. Afin d'obtenir le découplage maximal de la zone ZF vis-à-vis de la vibration du résonateur, le dimensionnement du dispositif selon l'invention est optimisé par exemple au moyen de simulations numériques basées sur la méthode des éléments finis. La compensation quasiment totale des effets de Poisson dus au cylindre creux et au résonateur peut être obtenue en ajustant l'amplitude de vibration longitudinale du cylindre creux car les effets de Poisson dus au cylindre creux sont proportionnels à ladite amplitude. Ainsi qu'évoqué précédemment, cet ajustement peut s'obtenir en agissant sur la masse du cylindre creux, par exemple en agissant sur l'épaisseur d2 de sa paroi. Sur la représentation illustrée, la dimension radiale d2 est de l'ordre de grandeur du diamètre $\phi$ du résonateur. Plus généralement, la dimension radiale d2 est de préférence comprise entre la moitié du diamètre $\phi$ et deux fois le diamètre $\phi$.

Il vient d'être expliqué le mécanisme par lequel, partant d'un résonateur R ayant un seul noeud N de vibration situé au coeur de sa matière, le module de découplage comportant une membrane 1 et un cylindre droit creux 2 permet que le dispositif 10 selon l'invention présente une zone de fixation ZF quasiment découplée de la vibration du résonateur et située sur la surface cylindrique extérieure du cylindre creux, donc facilement accessible pour y disposer un système de fixation du dispositif dans un boîtier. Ce système de fixation peut présenter diverses configurations.

Par exemple, la **figure 4** montre un système de fixation sous la forme de supports métalliques SM assemblés chacun à une extrémité sur la zone de fixation ZF et à l'autre extrémité sur une embase de boîtier EB (non représentée), ainsi qu'il est pratiqué dans la technique antérieure expliquée dans le préambule.

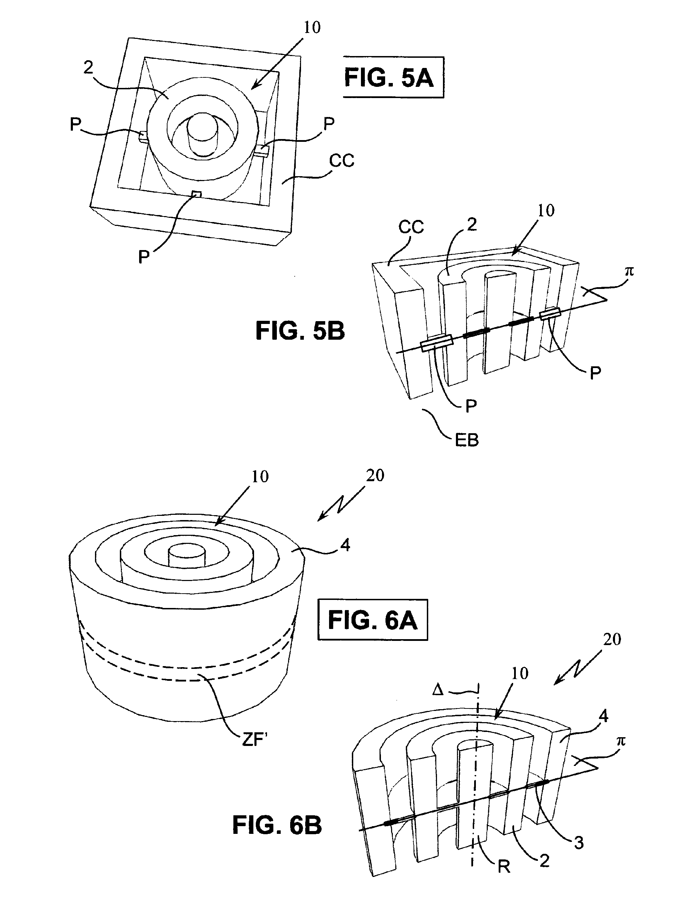

Toujours à titre d'exemple, les **figures 5A et 5B** montrent un système de fixation intégré au dispositif 10 selon l'invention, l'ensemble étant réalisé dans la même plaque plane de matériau. Le système de fixation comprend un cylindre droit creux CC de directrices sensiblement carrées entourant à distance le cylindre creux 2, et des ponts amincis P disposés dans le plan médian $\pi$ et solidaires de la surface cylindrique extérieure du cylindre creux 2 et de la surface cylindrique intérieure du cylindre creux CC. L'une des bases extérieures du cylindre creux CC est assemblée sur une embase de boîtier EB (non représentée). Ce système de fixation s'apparente ainsi à celui pratiqué dans la technique antérieure expliquée dans le préambule, et peut présenter l'intérêt de préserver le dispositif 10 selon l'invention d'effets parasites dus par exemple à la température ou à la présence d'un champ d'accélération. Mais le cylindre creux CC et les ponts P n'apportent rien vis-à-vis du découplage mécanique de la vibration du résonateur. De ce fait, la forme du cylindre creux CC a peu d'importance et peut par exemple être inspirée par la forme de l'embase de boîtier EB.

On se réfère maintenant aux **figures 6A et 6B** qui montrent un dispositif 20 selon une deuxième forme de réalisation de l'invention. Le dispositif 20 comprend le dispositif 10 précité, un cylindre droit creux additionnel 4 entourant à distance le cylindre creux 2 et ayant son axe central longitudinal et son plan médian confondus respectivement avec ceux du dispositif 10, et une membrane 3 additionnelle disposée dans ledit plan médian et solidaire de la surface cylindrique extérieure du cylindre creux 2 et de la surface cylindrique intérieure du cylindre creux additionnel 4.

La mise en oeuvre du dispositif 20 peut être intéressante par exemple pour élargir les tolérances de fabrication.

Le dispositif 20 présente un mode de résonance particulier pour lequel le cylindre creux 2 et le résonateur R vibrent en opposition de phase entre eux comme expliqué précédemment pour le dispositif 10, et le cylindre creux additionnel 4 vibre en opposition de phase avec le cylindre creux 2. Ainsi, des déplacements radiaux résiduels qui subsistent sur la surface extérieure du cylindre creux 2 au voisinage du plan médian, dus par exemple à des défauts de réalisation, voient leurs effets compensés par les déformations radiales du cylindre creux additionnel 4 dans une zone de fixation ZF' située sur la surface cylindrique extérieure du cylindre creux additionnel 4 au voisinage du plan médian, selon le même mécanisme que celui expliqué pour le dispositif 10. Le module de découplage du dispositif 20 peut donc être vu, tant au niveau de la configuration que de la fonction, comme la disposition en série de deux modules de découplage tels que décrits précédemment.

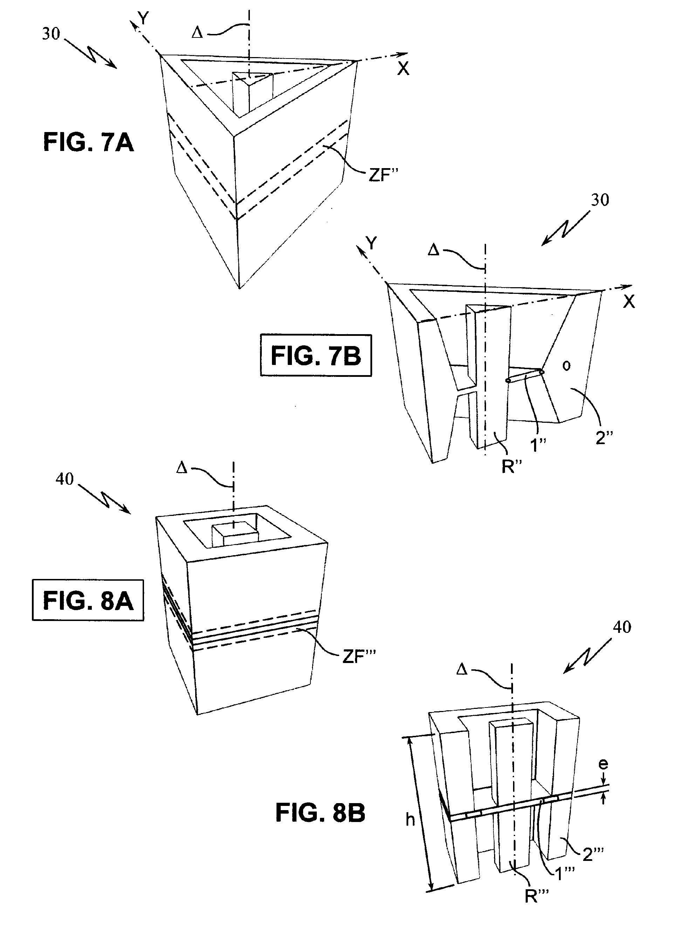

Les **figures 7A et 7B** montrent un dispositif monolithique 30 selon une troisième forme de réalisation de l'invention. Par rapport au dispositif 10, les principales différences portent sur les directrices triangulaires du résonateur R'' et du cylindre creux 2'', et sur la nature du matériau, le dispositif 30 étant réalisé dans une plaque plane de quartz parallèle au plan cristallographique XY, X étant l'axe électrique et Y l'axe mécanique. Le choix du quartz est intéressant lorsque le faible coût de réalisation est un critère déterminant. Ainsi, le dispositif 30 peut être réalisé par usinage chimique collectif d'une plaque de quartz selon un procédé voisin de celui pratiqué dans l'industrie horlogère pour la fabrication des quartz de montre. L'usinage chimique du quartz, effectué généralement dans un bain contenant de l'acide fluorhydrique, provoque dans la plupart des cas l'apparition de facettes obliques dont il faut généralement s'accommoder. Afin que le résonateur R'' obtenu par usinage chimique s'apparente à un cylindre droit, il est nécessaire que la directrice du cylindre soit un triangle équilatéral dont les cotés sont parallèles à un axe mécanique Y. On rappelle que le réseau cristallin trigonal du quartz implique qu'il y a dans le plan cristallographique XY trois axes X espacés angulairement de 120°, et trois axes Y également espacés angulairement de 120°. On rappelle également que l'usinage chimique d'un flanc parallèle à l'axe Y, lorsque la matière à enlever est du côté négatif de l'axe X correspondant, s'effectue quasiment perpendiculairement au plan XY jusqu'au fond de la gravure, c'est-à-dire pratiquement sans aucune facette oblique.

Ainsi, le résonateur R'' et la surface cylindrique extérieure du cylindre creux 2'' sont des cylindres droits. Par contre, la surface cylindrique intérieure du cylindre creux 2'' a la forme d'un tronc de cône de directrice triangulaire, ainsi qu'illustré sur la figure 7B. Ceci n'est pas un inconvénient pour le fonctionnement du dispositif 30 si l'on a soin de prendre en compte cette forme dans les simulations numériques servant à l'optimisation du dimensionnement du dispositif. L'homme du métier comprendra que l'expression « cylindre droit », telle qu'utilisée ici, est à considérer au sens large, l'important étant que le fonctionnement du dispositif 30 est similaire à celui du dispositif 10 décrit précédemment, et que le dispositif 30 peut être fixé sur une zone de fixation ZF'' située sur la surface extérieure du cylindre creux, ladite zone ZF'' étant quasiment découplée de la vibration du résonateur.

Les **figures 8A et 8B** montrent un dispositif 40 selon une quatrième forme de réalisation de l'invention. Par rapport au dispositif 10, les principales différences portent sur les directrices carrées du résonateur R''' et du cylindre creux 2''', et sur le caractère non monolithique du dispositif, le dispositif 40 étant réalisé dans une plaque de SOI (Silicon On Insulator). Plus précisément, la plaque de SOI est constituée de deux plaques planes identiques de silicium (Si) assemblées respectivement de part et d'autre d'une plaque plane de silice (SiO2). Le silicium, comme la silice, est un matériau de très faible amortissement visqueux. L'assemblage des plaques de silicium et de silice s'apparente généralement à une adhérence au niveau atomique, garante elle aussi d'un très faible amortissement visqueux. L'épaisseur e de la plaque de silice est de préférence inférieure à un dixième de l'épaisseur de chacune des plaques de silicium, c'est-à-dire inférieure à un vingtième de l'épaisseur totale h de la plaque de SOI.

Le dispositif 40 est réalisé au moyen d'un usinage plasma effectué sur les deux faces de la plaque de SOI. Les paramètres de l'usinage sont choisis pour que l'usinage soit sélectif, propre à graver efficacement le silicium et faiblement la silice. Ainsi, il est facile de contrôler la profondeur de gravure pour arrêter l'usinage lorsqu'il aborde la plaque de silice qui se comporte comme une couche d'arrêt. Ainsi, il est facile de réaliser le dispositif 40 dans lequel la membrane 1''' est en silice et le résonateur R''' et le cylindre creux 2''' très majoritairement en silicium.

Le silicium présente un réseau cristallin cubique. De ce fait, il est généralement avantageux de préférer la forme carrée pour les directrices du résonateur et du cylindre creux, les côtés du carré étant parallèles à des axes principaux du silicium, ce qui permet généralement un meilleur fonctionnement du dispositif 40.

En ce qui concerne en particulier la forme des directrices du cylindre creux, il peut être avantageux, afin d'améliorer encore le fonctionnement du dispositif, de s'écarter du carré parfait, en conservant toutefois l'allure générale de la forme carrée. Cela est mis en évidence par le travail d'optimisation de la géométrie du dispositif 40 par simulations numériques, le but de ce travail étant d'obtenir que la zone de fixation ZF''' soit quasiment découplée de la vibration du résonateur. Au plan de la faisabilité de réalisation, il n'y a pas de difficulté particulière à usiner la forme optimale issue des simulations numériques, car la réalisation du masque d'usinage utilisé pour la gravure plasma fait appel aux techniques photolithographiques.

Il doit donc être entendu que l'expression « directrice de forme carrée », telle qu'utilisée ici, est à considérer au sens large, et plus généralement que la forme des directrices du cylindre creux peut être sensiblement différente de celle de la directrice du résonateur.

Il vient d'être présenté des dispositifs selon l'invention, au plan principalement de leur comportement mécanique.

En ce qui concerne maintenant la façon d'exciter la vibration du résonateur, divers moyens peuvent être mis en oeuvre.

Par exemple, pour le dispositif 30 en quartz de forme triangulaire, des électrodes déposées sur les flancs usinés du cylindre creux permettent de générer un champ électrique selon l'axe électrique X, ledit champ électrique étant couplé par effet piézoélectrique à la compression et à l'extension alternative de l'épaisseur de la paroi du cylindre creux.

Toujours à titre d'exemple, pour les dispositifs 10 en silice et 40 en SOI, des plages métalliques ou des miroirs disposés sur les faces du résonateur affleurant les faces de la plaque permettent d'exciter la vibration du résonateur par effet électrostatique ou par effet optique tel que photothermique ou par pression de radiation. Du fait que lesdites faces du résonateur ne subissent quasiment aucune déformation mécanique mais seulement une translation alternative lors de la vibration du résonateur, lesdites plages métalliques et lesdits miroirs n'altèrent en rien le coefficient de qualité du résonateur, à condition toutefois qu'ils soient disposés sur les deux faces du résonateur afin de préserver l'équilibre des masses.

**Revendications**

1. Dispositif comportant un résonateur et un module de découplage mécanique, le résonateur étant formé d'un cylindre droit vibrant selon un mode d'extension-compression suivant son axe central longitudinal et présentant un noeud de vibration dans son plan médian perpendiculaire audit axe longitudinal, ladite vibration induisant naturellement des déformations radiales d'extension-compression, **caractérisé en ce que** le module de découplage comporte un cylindre droit creux entourant à distance le résonateur et ayant son axe central longitudinal et son plan médian confondus respectivement avec ceux du résonateur, la hauteur dudit cylindre creux étant sensiblement égale à celle du résonateur, et une membrane disposée dans ledit plan médian et solidaire de la surface cylindrique du résonateur et de la surface cylindrique intérieure du cylindre creux, et que le cylindre creux vibre selon un mode d'extension-compression suivant son axe longitudinal en opposition de phase avec la vibration du résonateur, ce grâce à quoi les effets des déformations radiales du cylindre creux et du résonateur se compensent dans une zone située sur la surface extérieure du cylindre creux au voisinage dudit plan médian.

**2.** Dispositif selon la revendication 1, **caractérisé en ce qu'**il comprend un cylindre droit creux additionnel entourant à distance le cylindre creux précité et ayant son axe central longitudinal et son plan médian confondus respectivement avec ceux du résonateur, et une membrane additionnelle disposée dans ledit plan médian et solidaire de la surface cylindrique extérieure du cylindre creux précité et de la surface cylindrique intérieure du cylindre creux additionnel, et que le cylindre creux additionnel vibre selon un mode d'extension-compression suivant son axe longitudinal en opposition de phase avec la vibration du cylindre creux précité.

**3.** Dispositif selon la revendication 1 ou 2, **caractérisé en ce qu'**il est réalisé dans une plaque plane de matériau, la dimension d'épaisseur de la plaque étant portée par l'axe longitudinal du résonateur.

**4.** Dispositif selon la revendication 3, **caractérisé en ce que** le dispositif est monolithique, et que ledit matériau est un matériau isotrope de très faible amortissement visqueux, tel la silice, et que les directrices du résonateur et du cylindre creux sont de forme circulaire.

**5.** Dispositif selon la revendication 3, **caractérisé en ce que** le dispositif est monolithique, et que ledit matériau est du quartz, la plaque étant parallèle au plan cristallographique XY, et que les directrices du résonateur et du cylindre creux ont la forme d'un triangle équilatéral dont chacun des côtés est parallèle à un axe Y.

**6.** Dispositif selon la revendication 3, **caractérisé en ce que** la plaque est une plaque de SOI, et que les directrices du résonateur et du cylindre creux ont la forme d'un carré dont les côtés sont parallèles à des axes principaux du silicium.

**Patentansprüche**

**1.** Vorrichtung mit einem Resonator und einem mechanischen Entkopplungsmodul, wobei der Resonator aus einem geraden Zylinder gebildet ist, der entsprechend einem Extensions-/Kompressionsmodus entlang seiner zentralen Längsachse schwingt und einen Schwingungsknotenpunkt in seiner Mittelebene senkrecht zur Längsachse aufweist, wobei die Schwingung naturgemäß radiale Extensions-/Kompressionsverformungen induziert, **dadurch gekennzeichnet, dass** das Entkopplungsmodul einen geraden Hohlzylinder, der den Resonator in einem Abstand umgibt und dessen zentrale Längsachse und seine Mittelebene jeweils mit denjenigen des Resonators ineinander übergehen, wobei die Höhe des Hohlzylinders im Wesentlichen gleich derjenigen des Resonators ist, und eine Membran umfasst, die in der Mittelebene angeordnet und fest mit der zylindrischen Fläche des Resonators und der zylindrischen Innenfläche des Hohlzylinders verbunden ist, und dass der Hohlzylinder entsprechend einem Extensions-/Kompressionsmodus entlang seiner Längsachse gegenphasig mit der Schwingung des Resonators schwingt, wodurch die Wirkungen der Radialverformungen des Hohlzylinders und des Resonators sich in einem Bereich kompensieren, der sich an der Außenfläche des Hohlzylinders im Nahbereich der Mittelebene befindet.

**2.** Vorrichtung nach Anspruch 1, **dadurch gekennzeichnet, dass** sie einen zusätzlichen geraden Hohlzylinder, der den vorgenannten Hohlzylinder in einem Abstand umgibt und dessen zentrale Längsachse und seine Mittelebene jeweils mit denjenigen des Resonators ineinander übergehen, und eine zusätzliche Membran umfasst, die in der Mittelebene angeordnet und fest mit der zylindrischen Außenfläche des vorgenannten Hohlzylinders und der zylindrischen Innenfläche des zusätzlichen Hohlzylinders verbunden ist, und dass der zusätzliche Hohlzylinder entsprechend einem Extensions-/Kompressionsmodus entlang seiner Längsachse gegenphasig mit der Schwingung des vorgenannten Hohlzylinders schwingt.

**3.** Vorrichtung nach Anspruch 1 oder 2, **dadurch gekennzeichnet, dass** sie aus einer flachen Materialplatte hergestellt ist, wobei die Dickenabmessung der Platte von der Längsachse des Resonators getragen ist.

**4.** Vorrichtung nach Anspruch 3, **dadurch gekennzeichnet, dass** die Vorrichtung monolithisch ist, und dass das Material ein isotropes Material mit sehr geringer viskoser Dämpfung wie etwa Siliciumoxid ist, und dass die Leitlinien des Resonators und des Hohlzylinders von Kreisform sind.

**5.** Vorrichtung nach Anspruch 3, **dadurch gekennzeichnet, dass** die Vorrichtung monolithisch ist, und dass das Material Quarz ist, wobei die Platte parallel zur kristallografischen Ebene XY ist, und dass die Leitlinien des Resonators und des Hohlzylinders die Form eines gleichseitigen Dreiecks haben, wovon jede der Seiten parallel zu einer Achse Y ist.

**6.** Vorrichtung nach Anspruch 3, **dadurch gekennzeichnet, dass** die Platte eine Platte aus SOI ist, und dass die Leitlinien des Resonators und des Hohlzylinders die Form eines Quadrats haben, dessen Seiten parallel zu Hauptachsen von Silicium sind.

**Claims**

**1.** A device including a resonator and a mechanical decoupling module, the resonator being formed by a right cylinder vibrating in extension/compression mode along its central longitudinal axis and having a vibration node in its mid-plane which is perpendicular to the longitudinal axis, said vibration naturally inducing radial extension/compression deformations, **characterized in that** the decoupling module includes a hollow right cylinder surrounding and spaced apart from the resonator and having its central longitudinal axis and its mid-plane coinciding respectively with those of the resonator, the height of the hollow cylinder being substantially equal to that of the resonator, and a membrane positioned in the mid-plane and connected to the cylindrical surface of the resonator and with the internal cylindrical surface of the hollow cylinder, and **in that** the hollow cylinder vibrates in extension/compression mode along its longitudinal axis in antiphase with the vibration of the resonator, as a result of which the effects of the radial deformations of the hollow cylinder and of the resonator compensate each other in an area located on the external surface of the hollow cylinder close to the mid-plane.

**2.** A device according to Claim 1, **characterized in that** it comprises an additional right hollow cylinder surrounding and spaced apart from the aforesaid hollow cylinder and having its central longitudinal axis and its mid-plane coinciding respectively with those of the resonator, and an additional membrane positioned in said mid-plane and rigidly connected to the external cylindrical surface of the aforesaid hollow cylinder and to the internal cylindrical surface of the additional hollow cylinder, and **in that** the additional hollow cylinder vibrates in extension/compression mode along its longitudinal axis in antiphase with the vibration of the aforesaid hollow cylinder.

**3.** A device according to Claim 1 or 2, **characterized in that** it is formed in a flat plate of material, the thickness dimension of the plate lying on the longitudinal axis of the resonator.

**4.** A device according to Claim 3, **characterized in that** the device is monolithic, and **in that** the material is an isotropic material with very low viscous damping, such as silica, and **in that** the directrices of the resonator and of the hollow cylinder are circular in shape.

**5.** A device according to Claim 3, **characterized in that** the device is monolithic, **in that** the material is quartz, the plate being parallel to the crystallographic plane XY, and **in that** the directrices of the resonator and of the hollow cylinder are in the shape of an equilateral triangle each of whose sides is parallel to a Y axis.

**6.** A device according to Claim 3, **characterized in that** the plate is a plate of SOI, and **in that** the directrices of the resonator and of the hollow cylinder are in the shape of a square whose sides are parallel to the main axes of the silicon.

**FIG. 1A**

**FIG. 1B**

**FIG. 2A**

**FIG. 2B**

FIG. 3A

FIG. 3B

FIG. 4

FIG. 5A

FIG. 5B

FIG. 6A

FIG. 6B

30

Y

Δ

X

**FIG. 7A**

ZF"

Y

Δ

30

X

**FIG. 7B**

o

1"

2"

R"

40

Δ

**FIG. 8A**

ZF'''

40

Δ

**FIG. 8B**

e

h

2'''

1'''

R'''

**EP 2 591 549 B1**

**RÉFÉRENCES CITÉES DANS LA DESCRIPTION**

**Documents brevets cités dans la description**

- US 4381471 A
- FR 2338607
- US 4135108 A
- DE 2148064 A1